# EUROPEAN PATENT APPLICATION

(11) **EP 4 815 665 A1**
(43) Date of publication of application: **30.09.2026**
(21) Application number: 25207914.0
(22) Date of filing: 10.10.2025
(51) Int. Cl.: H10D 30/01, H10D 30/66, H10D 62/13

(54) **POWER MOSFET DEVICE HAVING A SOURCE REGION EMBEDDED VIA EPITAXIAL GROWTH AND MANUFACTURING METHOD FOR POWER MOSFET DEVICE**

(30) Priority: 27.03.2025 CN 202510377419
(71) Applicant: Chongqing Alpha and Omega Semiconductor Limited, Chongqing 400700 (CN)
(72) Inventor: YANG, LI, Chongqing, 400700 (CN)
(74) Representative: Metida

(57) **Abstract**

A manufacturing method for a power MOSFET device having a source region embedded via epitaxial growth, includes: growing an epitaxial layer on a silicon substrate; forming a trench gate structure on the epitaxial layer, forming a silicon platform on two sides of the trench gate structure; forming a body region on an upper part of the epitaxial layer by injecting impurities; activating the impurities in the body region through a thermal process; oxidizing surfaces of the trench gate structure and the silicon platform to form a surface oxide layer; removing the surface oxide layer formed on the silicon platform; and growing a source region on the silicon platform via epitaxial growth; preparing a source contact penetrating the source region and extending into the body region, forming an ohmic contact area at a bottom of the source contact; and performing subsequent preparing processes.

## Description

### TECHNICAL FIELD

Embodiments of the present disclosure relate to the technical field of power MOSFET devices, and more specifically, to a power MOSFET device having a source region embedded via epitaxial growth and a manufacturing method for the power MOSFET device.

### BACKGROUND

In order to achieve better on-resistance (Rdson) performance, a conductive trench in a discrete power device tends to be shorter. In the power device having a short trench, a source region is formed by ion implantation and thermal process activation, and a depth of a PN junction of may significantly affect a length of the trench. Specifically, impurities in the source region may be diffused into a body region during the thermal process activation, such that a depth of a junction in the source-body region may not be easily controlled. When the depth of the junction in the source-body region junction is relatively deep, a threshold voltage (Vth) may be significantly low. Therefore, the above process may cause the threshold voltage (Vth) of the power device to be widely distributed, and during mass production, manufacturing processing may not be controlled properly, causing yield losses.

### SUMMARY

In order to solve the above technical problem, the present disclosure provides a power MOSFET device having a source region embedded via epitaxial growth and a manufacturing method for the power MOSFET device.

The present disclosure provides a manufacturing method for a power MOSFET device having a source region embedded via epitaxial growth. The manufacturing method includes following operations.

In S100, growing an epitaxial layer on a silicon substrate.

In S200, forming a trench gate structure on the epitaxial layer, forming a silicon platform on two sides of the trench gate structure.

In S300, forming a body region on an upper part of the epitaxial layer by injecting impurities in the upper part of the epitaxial layer; activating the impurities in the body region through a thermal process; oxidizing a surface of the trench gate structure and an exposed silicon surface of the silicon platform to form a surface oxide layer.

In S400, removing the surface oxide layer formed on the silicon surface of the silicon platform; and growing a source region on the silicon platform via epitaxial growth.

In S500, preparing a source contact penetrating the source region and extending into the body region, forming an ohmic contact area at a bottom of the source contact.

In S600, performing subsequent preparing processes.

In some embodiments, the forming the trench gate structure includes following sub-operations.

In S210, sequentially preparing a silicon dioxide pad layer, a first mask layer, and a second mask layer on the epitaxial layer, where the silicon dioxide pad layer, the first mask layer, and the second mask layer form a hard mask.

In S220, performing etching, based on photolithography and photoresist, to form a gate trench pattern on the hard mask and performing etching on the epitaxial layer to form a gate trench.

In S230, removing the photoresist and the second mask layer via wet etching, and performing wet cleaning.

In S240, performing thermal oxidation to grow a layer of silicon dioxide, serving as a sacrificial oxide layer, on a trench wall of the gate trench; and removing the sacrificial oxide layer via wet etching.

In S250, performing thermal oxidation to grow a gate oxide layer on the trench wall of the gate trench.

In S260, depositing gate polysilicon via low-pressure chemical vapor deposition.

In S270, removing a part of the gate polysilicon protruding above a surface of the first mask layer via chemical mechanical planarization.

In S280, removing the first mask layer via wet etching; a part of the gate polysilicon corresponding to the first mask layer protruding out of a plane on which an opening of the gate trench is arranged, so as to form a gate protrusion structure.

In S290, adjusting configuration of the gate polysilicon on the silicon platform via dry etching to obtain the trench gate structure.

In some embodiments, in the S300, a thickness of the surface oxide layer grown on a surface of the gate polysilicon protruding from the trench gate structure is 10 is 500 Å to 600 Å, and a thickness of the surface oxide layer grown on the surface of the silicon platform is 300 Å to 400 Å.

In some embodiments, the S500 further includes following sub-operations.

In S510, forming a silicon dioxide dielectric layer on the epitaxial layer via chemical vapor deposition.

In S520, defining a pattern of a source contact hole using photoresist and forming the source contact hole by dry etching the silicon dioxide dielectric layer and the epitaxial layer.

In S530, forming the ohmic contact area at the bottom of the source contact hole via ion implantation.

In S540, activating the impurities through rapid thermal annealing.

In S550, depositing metal tungsten in the source contact hole via a tungsten plug process, and removing a part of the metal tungsten disposed out of the source contact hole via dry etching to form a tungsten plug, serving as the source contact, within the source contact hole.

In some embodiments, a thickness of the surface oxide layer grown on a surface of the gate polysilicon is greater than a thickness of the surface oxide layer grown on the surface of the silicon platform; and the removing the surface oxide layer formed on the silicon surface of the silicon platform in the S400 includes: performing dry etching or wet etching to remove the surface oxide layer formed on the surface of the silicon platform, so as to expose the silicon surface of the silicon platform.

In some embodiments, removing the surface oxide layer formed on the silicon surface of the silicon platform in the S400 includes: performing photolithography, based on a mask, to etch away the surface oxide layer formed on the silicon surface of the silicon platform, so as to expose the silicon surface of the silicon platform.

In some embodiments, the manufacturing method further includes: growing a silicon layer via epitaxial growth to form the source region at a temperature of 700°C to 900°C.

In some embodiments, the manufacturing method further includes: growing the silicon layer via epitaxial growth to form the source region, and at the same time, performing in-situ doping with corresponding impurities. A doping concentration is in a range of E18 cm⁻³ to E19 cm⁻³, and a doping concentration peak is in a range of E19 cm⁻³ to E20 cm⁻³.

In some embodiments, after the growing the silicon layer via epitaxial growth to form the source region, the manufacturing method further includes: S410, performing ion implantation to the source region and performing rapid thermal annealing activation.

The present disclosure provides a power MOSFET device having a source region embedded via epitaxial growth, formed by performing the manufacturing method according to any of the above embodiments.

According to the present disclosure, the source region is formed by epitaxial growth and in-situ doping of corresponding impurities simultaneously. In this way, a height of the source region is elevated, and the depth of the junction in the source-body region may be precisely controlled, preventing the depth of the junction in the source-body region from being excessively deep. Therefore, control over distribution of the threshold voltage of the power MOSFET device having the short trench may be improved. Manufacturing processes of the power MOSFET device having the short trench may be controlled more simply, and mass production yield of low-resistance power MOSFET devices may be improved.

### BRIEF DESCRIPTION OF THE DRAWINGS

FIG. 1 is a structural schematic view of a power MOSFET device in the related art.
FIG. 2 is a structural schematic view of another power MOSFET device in the related art.
FIG. 3 is a flow chart of a manufacturing method for a power MOSFET device having a source region embedded via epitaxial growth, according to some embodiments of the present disclosure.
FIG. 4 is a structural schematic view of a structure obtained after a hard mask being formed, according to some embodiments of the present disclosure.
FIG. 5 is a structural schematic view of a structure obtained after a gate trench pattern being formed by etching, according to some embodiments of the present disclosure.
FIG. 6 is a structural schematic view of a structure obtained after a gate trench being formed by etching, according to some embodiments of the present disclosure.
FIG. 7 is a structural schematic view of a structure obtained after a second mask layer being etched away, according to some embodiments of the present disclosure.
FIG. 8 is a structural schematic view of a structure obtained after a gate oxide layer being grown, according to some embodiments of the present disclosure.
FIG. 9 is a structural schematic view of a structure obtained after a trench gate structure being formed, according to some embodiments of the present disclosure.
FIG. 10 is a structural schematic view of a structure obtained after a body region being formed by injection, according to some embodiments of the present disclosure.
FIG. 11 is a structural schematic view of a structure obtained after the source region being formed via epitaxial growth, according to some embodiments of the present disclosure.
FIG. 12 is a structural schematic view of a structure obtained after a source contact hole and an ohmic contact area being formed, according to some embodiments of the present disclosure.
FIG. 13 is a structural schematic view of a structure obtained after a source contact being formed, according to some embodiments of the present disclosure.

### DETAILED DESCRIPTIONS

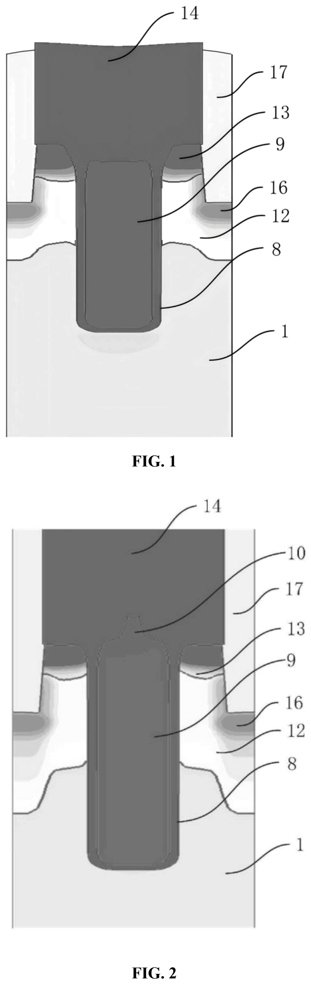

FIG. 1 shows a power MOSFET device available in the related art. A gate polysilicon 9 of the power MOSFET device in the related art is formed after back-etching, such that a height of the polysilicon 9 is lower than a height of a silicon platforms 7 disposed at two sides of the polysilicon 9. FIG. 2 shows another power MOSFET device available in the related art. The gate polysilicon 9 is formed by chemical mechanical polishing after forming a hard mask, such that a gate protrusion structure 10 that protrudes out of a surface of the silicon platform 7 is created at the hard mask. Although the gate polysilicon 9 in the power MOSFET device in FIG. 1 and the gate polysilicon 9 in the power MOSFET device in FIG. 2 are structurally different from each other, a source region 13 in the power MOSFET device in FIG. 1 and a source region 13 in the power MOSFET device in FIG. 2 are both activated by an ion implantation process (with an implantation concentration of 10¹⁵ cm⁻³ approximately and a concentration peak formed at 10¹⁹ cm⁻³ to 10²⁰ cm⁻³) and a high-temperature thermal process (900°C to 1000°C for 30 to 60 minutes). Therefore, a threshold voltage Vth of each of the power MOSFET device in FIG. 1 and the power MOSFET device in FIG. 2 is widely distributed, and therefore, during mass production, manufacturing processes may not be easily controlled.

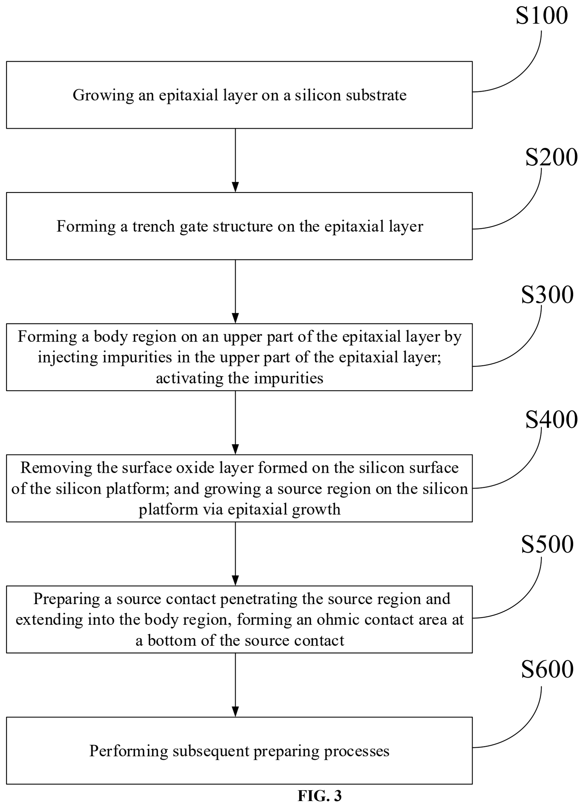

FIG. 3 is a flow chart of a manufacturing method for a power MOSFET device having a source region embedded via epitaxial growth, according to some embodiments of the present disclosure. The manufacturing method of the present disclosure includes following operations.

In S100, an epitaxial layer 1 is growing on a silicon substrate. The epitaxial layer 1 may include one or more layers. The epitaxial layer 1 is typically formed via chemical vapor deposition and may be doped with trivalent elements (such as boron) or pentavalent elements (such as arsenic, phosphorus) based on polarity of the power MOSFET device. A thickness of the epitaxial layer 1 is typically determined based on an operating voltage, or the epitaxial layer 1 may be configured as a multi-layer structure based on the operating voltage.

It should be noted that the drawings show only the epitaxial layer 1, and the silicon substrate beneath the epitaxial layer 1 is omitted. Furthermore, the drawings are schematic views of relevant regions of one unit cell during the manufacturing process, and a complete structural schematic view is not shown.

In S200, a trench gate structure is prepared on the epitaxial layer 1, a silicon platform 7 is formed on two sides of the trench gate structure. Preparing the trench gate structure may include following sub-operations.

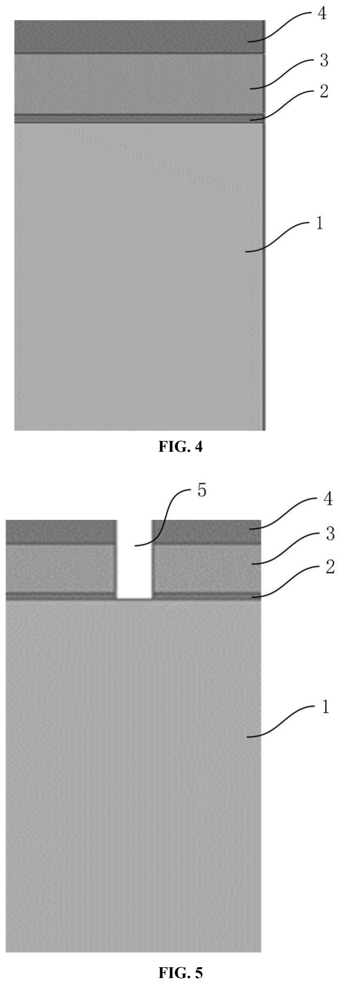

In S210, as shown in FIG. 4, a silicon dioxide pad layer 2, a first mask layer 3, and a second mask layer 4 are sequentially prepared on the epitaxial layer 1. The silicon dioxide pad layer 2, the first mask layer 3, and the second mask layer 4 form a hard mask. In the present embodiment, a material of the first mask layer 3 may be silicon nitride, and a material of the second mask layer 4 may be silicon dioxide. In this way, the hard mask forms an insulating mask of silicon dioxide-silicon nitride-silicon dioxide, which is a multi-layer structure. Both the silicon nitride of the first mask layer 3 and the silicon dioxide of the second mask layer 4 may be prepared via chemical vapor deposition.

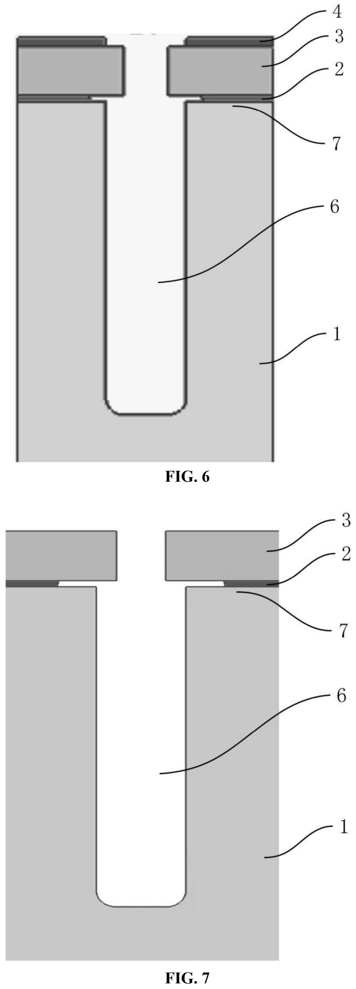

In S220, as shown in FIG. 5, a gate trench pattern 5 is formed by performing a photolithography process on the hard mask. Subsequently, as shown in FIG. 6, a gate trench 6 is formed in the epitaxial layer 1 by etching. Specifically, in the present operation, a photoresist is firstly arranged to cover the second mask layer 4. A pattern of the gate trench 6 pattern is exposed on the photoresist based on a mask. Subsequently, dry etching is performed based on the pattern on the photoresist to etch the second mask layer 4, the first mask layer 3, and the silicon dioxide pad layer 2, so as to form the gate trench pattern 5 on the hard mask. Finally, dry etching is performed to form the gate trench 6 on epitaxial layer 1 based on the gate trench pattern 5.

In S230, as shown in FIG. 7, the photoresist and the second mask layer 4 are removed via wet etching, and wet cleaning is performed. Since both the silicon dioxide pad layer 2 and the second mask layer 4 in the present embodiment are silicon dioxide, a part of the silicon dioxide pad layer 2 may be removed during performing the wet etching to remove the second mask layer 4.

In S240, a thermal oxidation process is performed to grow a layer of silicon dioxide, serving as a sacrificial oxide layer, on a trench wall of the gate trench 6, and the sacrificial oxide layer is removed via wet etching. A thickness of the sacrificial oxide layer is 5 nm to 50 nm. By forming the sacrificial oxide layer, the thermal oxidation process may perform rounding and plasma damage repair on cell trenches and gate interconnect trenches.

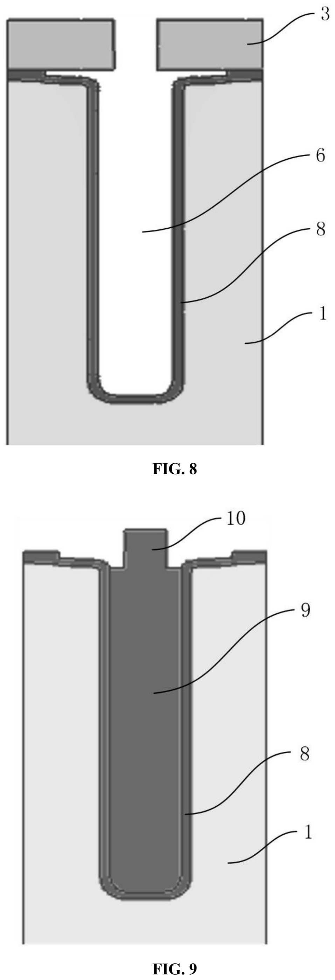

In S250, as shown in FIG. 8, a gate oxide layer 8 is grown on the trench wall of the gate trench 6 through the thermal oxidation process. A thickness of the grown gate oxide layer 8 is determined based on required performance of the power MOSFET device, and the thickness of the grown gate oxide layer 8 may be in a range from 5 nm to 50 nm.

In S260, as shown in FIG. 9, a gate polysilicon 9 is deposited via low-pressure chemical vapor deposition. The gate polysilicon 9 must fully fill the gate trench 6. A thickness of the gate polysilicon 9 is determined by an actual depth of the gate trench 6.

In S270, as shown in FIG. 9, a part of the gate polysilicon 9 protruding above a surface of the first mask layer 3 is removed via chemical mechanical polishing. Since a point at which the chemical mechanical polishing stops cannot be precisely set, during the chemical mechanical polishing, the chemical mechanical polishing is performed to reach a position slightly below the surface of the first mask layer 3

In S280, as shown in FIG. 9, the first mask layer 3 is removed via wet etching. During the operation S280, a part of the gate polysilicon 9 corresponding to the first mask layer 3 protrudes upward beyond a plane on which an opening of the gate trench 6 is arranged, so as to form a gate protrusion structure 10.

In S290, as shown in FIG. 9, configuration of the gate polysilicon 9 on the silicon platform 7 is adjusted via dry etching to obtain the trench gate structure. The present operation primarily aims to remove a part of the gate polysilicon 9 extending laterally from the gate trench into the silicon platform 7. In this way, ion implantation at a later stage may not be affected, and a gate resistance is adjusted. Of course, the part of the gate polysilicon 9 extending laterally from the gate trench 6 into the silicon platform 7 may not be fully removed, and a small amount of the part of the gate polysilicon 9 may be left on the silicon platform 7 at a region that would not affect the ion implantation into the body region 12.

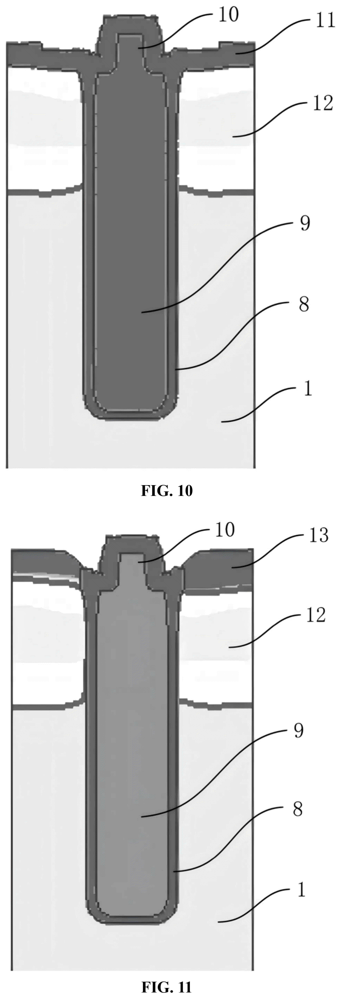

In S300, as shown in FIG. 10, the body region 12 is formed by performing the ion implantation to inject impurities into an upper portion of the epitaxial layer 1, and a thermal process is performed to activate the impurities in the body region 12. The impurities implanted to form the body region 12 may be trivalent elements or pentavalent elements, and a type of the trivalent elements or the pentavalent elements is determined based on the polarity of the power MOSFET device. During performing the thermal process to activate the impurities in the body region 12, a surface of the trench gate structure and an exposed surface of the silicon platform 7 are oxidized into silicon dioxide, so as to form a surface oxide layer 11. Due to lattice, the surface oxide layer 11 grown on the gate polysilicon 9 protruding from the trench gate structure (i.e., gate protrusion structure 10) is thicker than the surface oxide layer 11 grown on the surface of the silicon platform 7. In the present embodiment, a thickness of the surface oxide layer 11 grown on the surface of the gate protrusion structure 10 is 500 Å to 600 Å, and a thickness of the surface oxide layer 11 grown on the surface of the silicon platform 7 is 300 Å to 400 Å. A thickness difference facilitates the surface oxide layer 11 to be etched at a later stage for growing the source region 13, while preserving the surface oxide layer 11 on the polysilicon surface.

In S400, as shown in FIG. 11, the surface oxide layer 11 on the surface of the silicon platform 7 is removed, and a source region 13 is grown and formed on the silicon platform 7 via epitaxial growth.

Removing the surface oxide layer 11 on the silicon platform 7 may be achieved by performing either of the following two methods.

For one of the two methods, a photolithography process is performed based on a mask to etch away the surface oxide layer 11 on the silicon platform 7, exposing a silicon surface of the silicon platform 7. For the other one of the two methods, according to the situation that the surface oxide layer 11 grown on the polysilicon surface is thicker than the surface oxide layer 11 grown on the surface of the silicon platform 7, the surface oxide layer 11 on the surface of the silicon platform 7 is removed via dry etching or wet etching, exposing the silicon surface of the silicon platform 7. At this case, since the surface oxide layer 11 on the gate protrusion structure 10 is thicker, the surface of the gate protrusion structure 10 remains being covered by the surface oxide layer 11.

In the present embodiment, the source region 13 is formed by growing a silicon layer via the epitaxial growth at a temperature of 700°C to 900°C. During growing the silicon layer via the epitaxial growth, corresponding impurities may be in-situ doped, with a doping concentration in a range of E18 cm⁻³ to E19 cm⁻³, forming a concentration peak at E19 cm⁻³ to E20 cm⁻³. The impurities doped in-situ during growing the source region 13 may be a trivalent element or a pentavalent element. Polarity of the doped impurities is opposite to the polarity of the impurities injected into the body region 12 (i.e., when the body region 12 is injected with a trivalent element as the impurities, the source region 13 is in-situ doped with the pentavalent element as the impurities; when the body region 12 is injected with a pentavalent element as the impurities, the source region 13 is in-situ doped with the trivalent element as the impurities). When manufacturing an NMOS-type device, the impurities in-situ doped in the source region 13 are the trivalent element (such as phosphorus, arsenic). When manufacturing a PMOS-type device, the impurities in-situ doped in the source region 13 are the pentavalent element (such as boron).

After forming the source region 13 by growing the silicon layer via the epitaxial growth, following operations may further be performed.

In S410, another ion implantation is performed to the source region 13, and rapid thermal annealing activation is performed, so as to reduce a resistance of the source region 13.

In S500, a source contact penetrating the source region 13 and extending into the body region 12 is prepared, an ohmic contact area 16 is formed at a bottom of the source contact. The present operation S500 may include following sub-operations.

In S510, a silicon dioxide dielectric layer 14 is formed on the epitaxial layer 1 via chemical vapor deposition.

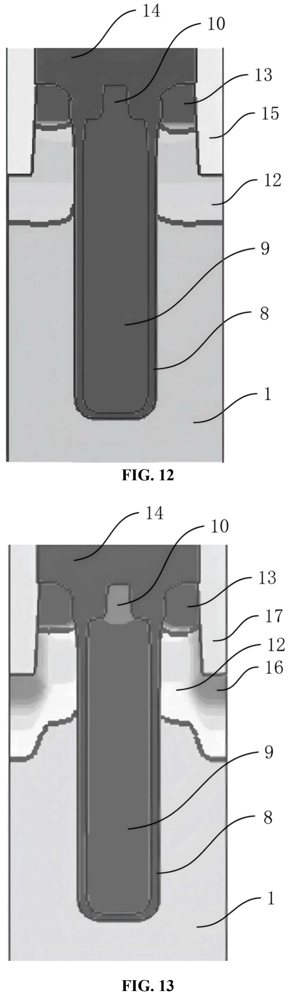

In S520, as shown in FIG. 12, a pattern of the source contact hole 15 is defined using photoresist, and the silicon dioxide dielectric layer 14 and the epitaxial layer 1 are etched by dry etching to form the source contact hole 15.

In S530, as shown in FIG. 13, ion implantation is performed to dope high concentration of impurities into the bottom of the source contact hole 15 to form the ohmic contact area 16 at the bottom of the source contact hole 15. In the present sub-operation, polarity of elements of the impurities that are ion-implanted is opposite to that of the elements of the impurities doped in the source region 13.

In S540, the impurities are activated by rapid thermal annealing.

In S550, as shown in FIG. 13, the metal tungsten is deposited in the source contact hole 15 via a tungsten plug process, a part of the tungsten disposed outside the source contact hole 15 is removed via dry etching, so as to form a tungsten plug 17 within the source contact hole 15 to serve as the source contact. Before depositing the tungsten, metals and nitrides may be deposited via physical vapor deposition to serve as a contact hole protection layer (not shown). Rapid thermal degradation is performed to form silicides; and the metals may include one or more of: titanium, cobalt, or tantalum.

In S600, subsequent preparing processes are performed. The subsequent preparing processes typically include: depositing aluminum-copper compounds over the tungsten plug 17 via physical vapor deposition; and forming circuits by performing photolithography and dry etching; depositing a passivation layer and etching the passivation layer to form openings via photolithography (the passivation layer typically includes silicon nitride or silicon dioxide); performing alloy annealing, and so on. These are conventional processes for preparing the power MOSFET device in the related art and are unrelated to improvements of the present embodiment, and therefore, these processes are not elaborated in detail here.

In the present embodiment, TCAD simulation of the power MOSFET device shown in FIG. 2 is obtained. According to results, a potential gradient of the source region 13 of the power MOSFET device shown in FIG. 2 is widely distributed. In the present embodiment, TCAD simulation of the power MOSFET device of the present embodiment is obtained. According to results, a potential gradient of the source region 13 of the power MOSFET device of the present disclosure is narrower. In the present embodiment, simulation of the power MOSFET device shown in FIG. 2 and simulation of the power MOSFET device of the present disclosure are obtained. According to results, no difference is shown between a peak voltage of the threshold voltage Vth of the power MOSFET device shown in FIG. 2 and a peak voltage of the threshold voltage Vth of the power MOSFET device of the present disclosure, and no significant difference is formed between a dynamic parameter of the power MOSFET device shown in FIG. 2 and a dynamic parameter of the power MOSFET device of the present disclosure. In the present embodiment, simulation of the power MOSFET device shown in FIG. 2 and simulation of the power MOSFET device of the present disclosure are obtained. According to results, a leakage current of the power MOSFET device of the present disclosure is significantly reduced compared to a leakage current of the power MOSFET device shown in FIG. 2, and therefore, an optimization objective of the power MOSFET device of the present disclosure is achieved. In the present embodiment, simulation of the power MOSFET device shown in FIG. 2 and simulation of the power MOSFET device of the present disclosure are obtained, and impurity concentration distribution of the power MOSFET device shown in FIG. 2 and impurity concentration distribution of the power MOSFET device of the present disclosure are shown. According to results, the depth of the junction of the source-body region of the power MOSFET device of the present disclosure is effectively controlled and is 0.1 µm to 0.2 µm shallower than that in the power MOSFET device shown in FIG. 2, and the length of the trench in the body region 12 of the power MOSFET device of the present disclosure is effectively controlled.

According to the present disclosure, the source region 13 is formed by epitaxial growth (and is in-situ doped with corresponding impurities simultaneously). In this way, the depth of the junction in the source-body region may be precisely controlled, preventing the depth of the junction in the source-body region from being excessively deep. Therefore, control over distribution of the threshold voltage of the power MOSFET device having the short trench may be improved. Manufacturing processes of the power MOSFET device having the short trench may be controlled more simply, and mass production yield of low-resistance power MOSFET devices may be improved.

The present invention further provides a power MOSFET device having a source region embedded via epitaxial growth. The power MOSFET device may be prepared by performing any of the above methods for producing the power MOSFET device having the source region embedded via epitaxial growth. In the present embodiment, the source region 13 of the power MOSFET device is formed by epitaxial growth, the range of the threshold voltage Vth is more stable, and the product yield of the power MOSFET device is higher.

## Claims

1. A manufacturing method for a power MOSFET device having a source region embedded via epitaxial growth, comprising:
S100, growing an epitaxial layer on a silicon substrate;
S200, forming a trench gate structure on the epitaxial layer, forming a silicon platform on two sides of the trench gate structure;
S300, forming a body region on an upper part of the epitaxial layer by injecting impurities in the upper part of the epitaxial layer; activating the impurities in the body region through a thermal process; oxidizing a surface of the trench gate structure and an exposed silicon surface of the silicon platform to form a surface oxide layer;
S400, removing the surface oxide layer formed on the silicon surface of the silicon platform; and growing a source region on the silicon platform via epitaxial growth;
S500, preparing a source contact penetrating the source region and extending into the body region, forming an ohmic contact area at a bottom of the source contact; and
S600, performing subsequent preparing processes.

2. The manufacturing method according to claim 1, wherein, the forming the trench gate structure comprises:
S210, sequentially preparing a silicon dioxide pad layer, a first mask layer, and a second mask layer on the epitaxial layer, wherein the silicon dioxide pad layer, the first mask layer, and the second mask layer form a hard mask;
S220, performing etching, based on photolithography and photoresist, to form a gate trench pattern on the hard mask and performing etching on the epitaxial layer to form a gate trench;
S230, removing the photoresist and the second mask layer via wet etching, and performing wet cleaning;
S240, performing thermal oxidation to grow a layer of silicon dioxide, serving as a sacrificial oxide layer, on a trench wall of the gate trench; and removing the sacrificial oxide layer via wet etching;
S250, performing thermal oxidation to grow a gate oxide layer on the trench wall of the gate trench;
S260, depositing gate polysilicon via low-pressure chemical vapor deposition;
S270, removing a part of the gate polysilicon protruding above a surface of the first mask layer via chemical mechanical planarization;
S280, removing the first mask layer via wet etching; a part of the gate polysilicon corresponding to the first mask layer protruding out of a plane on which an opening of the gate trench is arranged, so as to form a gate protrusion structure;
S290, adjusting configuration of the gate polysilicon on the silicon platform via dry etching to obtain the trench gate structure.

3. The manufacturing method according to claim 1, wherein, in the S300, a thickness of the surface oxide layer grown on a surface of the gate polysilicon protruding from the trench gate structure is 10 is 500 Å to 600 Å, and a thickness of the surface oxide layer grown on the surface of the silicon platform is 300 Å to 400 Å.

4. The manufacturing method according to claim 1, wherein the S500 further comprises:
S510, forming a silicon dioxide dielectric layer on the epitaxial layer via chemical vapor deposition;
S520, defining a pattern of a source contact hole using photoresist and forming the source contact hole by dry etching the silicon dioxide dielectric layer and the epitaxial layer;
S530, forming the ohmic contact area at the bottom of the source contact hole via ion implantation;
S540, activating the impurities through rapid thermal annealing;
S550, depositing metal tungsten in the source contact hole via a tungsten plug process, and removing a part of the metal tungsten disposed out of the source contact hole via dry etching to form a tungsten plug, serving as the source contact, within the source contact hole.

5. The manufacturing method according to claim 1, wherein, a thickness of the surface oxide layer grown on a surface of the gate polysilicon is greater than a thickness of the surface oxide layer grown on the surface of the silicon platform; and the removing the surface oxide layer formed on the silicon surface of the silicon platform in the S400 comprises: performing dry etching or wet etching to remove the surface oxide layer formed on the surface of the silicon platform, so as to expose the silicon surface of the silicon platform.

6. The manufacturing method according to claim 1, wherein, removing the surface oxide layer formed on the silicon surface of the silicon platform in the S400 comprises: performing photolithography, based on a mask, to etch away the surface oxide layer formed on the silicon surface of the silicon platform, so as to expose the silicon surface of the silicon platform.

7. The manufacturing method according to any one of claims 1 to 6, wherein, the manufacturing method further comprises: growing a silicon layer via epitaxial growth to form the source region at a temperature of 700°C to 900°C.

8. The manufacturing method according to claim 7, wherein, the manufacturing method further comprises:
growing the silicon layer via epitaxial growth to form the source region, and at the same time, performing in-situ doping with corresponding impurities, wherein a doping concentration is in a range of E18 cm⁻³ to E19 cm⁻³, and a doping concentration peak is in a range of E19 cm⁻³ to E20 cm⁻³.

9. The manufacturing method according to claim 7, wherein, after the growing the silicon layer via epitaxial growth to form the source region, the manufacturing method further comprises:
S410, performing ion implantation to the source region and performing rapid thermal annealing activation.

10. A power MOSFET device having a source region embedded via epitaxial growth, formed by performing the manufacturing method according to any one of claims 1 to 9.
